(19) Europäisches Patentamt
European Patent Office
Office européen des brevets

(11) **EP 2 041 388 B1**

(12) **EUROPÄISCHE PATENTSCHRIFT**

(45) Veröffentlichungstag und Bekanntmachung des Hinweises auf die Patenterteilung:
**04.05.2016 Patentblatt 2016/18**

(21) Anmeldenummer: **07722527.4**

(22) Anmeldetag: **15.06.2007**

(51) Int Cl.:
***E06B 9/24*** *(2006.01)*

(86) Internationale Anmeldenummer:
**PCT/DE2007/001064**

(87) Internationale Veröffentlichungsnummer:
**WO 2008/003281 (10.01.2008 Gazette 2008/02)**

(54) **SONNENSCHUTZVORRICHTUNG MIT WINKELSELEKTIVER TRANSMISSION**

SUN PROTECTION DEVICE WITH ANGLE-SELECTIVE TRANSMISSION PROPERTIES

DISPOSITIF PARE-SOLEIL À TRANSMISSION ANGULAIREMENT SÉLECTIVE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **01.07.2006 DE 102006030529
20.03.2007 DE 102007013331**

(43) Veröffentlichungstag der Anmeldung:
**01.04.2009 Patentblatt 2009/14**

(73) Patentinhaber: **Fraunhofer-Gesellschaft zur Förderung der
angewandten Forschung e.V.
80686 München (DE)**

(72) Erfinder: **KUHN, Tilmann
79856 Hinterzarten (DE)**

(74) Vertreter: **Gagel, Roland
Patentanwalt Dr. Roland Gagel
Landsberger Strasse 480a
81241 München (DE)**

(56) Entgegenhaltungen:
**EP-A- 1 054 289     EP-A2- 0 170 472
US-A- 2 327 918     US-A- 2 545 906**

**Beschreibung**

**Technisches Anwendungsgebiet**

Die vorliegende Erfindung betrifft eine Sonnenschutzvorrichtung, insbesondere eine Verglasung, die wenigstens eine erste Strukturschicht aus einem opaken oder nur teilweise lichtdurchlässigen Material auf einer optisch transparenten dielektrischen Schicht oder Schichtfolge und eine zweite Strukturschicht aus einem opaken oder nur teilweise lichtdurchlässigen Material umfasst, wobei die erste und die zweite Strukturschicht unter Bildung von Lichtdurchgangsöffnungen oder - bereichen und lichtundurchlässigen oder lichtschwächenden Bereichen strukturiert sind.

Im Fassadenbau - insbesondere bei Bürobauten - hat der Anteil der verglasten Flächen in den letzten Jahren kontinuierlich zugenommen. Dies kann neben dem positiven Effekt eines höheren Tageslichtangebots allerdings auch zu einer Überhitzung der Büroräume führen, weshalb ein ausreichender Sonnenschutz vorgesehen werden muss. Dieser Sonnenschutz sollte einerseits zumindest teilweise eine Durchsicht nach außen erlauben und zu einer guten Raumausleuchtung führen, aber andererseits auch ausreichend Sonnenschutz bieten und Blendung vermeiden.

**Stand der Technik**

Neben flexiblen, verstellbaren Bauarten von Sonnenschutzvorrichtungen wie Jalousien oder textilen Rollos existieren auch feststehende oder bewegliche Behänge. So zeigen die DE 101 61 159 A1 und die DE 101 39 583 A1 Sonnenschutzvorrichtungen, die aus einer parallelen Anordnung horizontaler Metallstäbe aufgebaut sind, deren Querschnittsgeometrie hinsichtlich der Lichtlenkung optimiert ist. Durch einen Abstand zwischen den Stäben wird gleichzeitig die Durchsicht ermöglicht.

Kommerziell sind Verbundglasscheiben erhältlich, in die ein Streckmetall mit Durchgangsschlitzen einlaminiert ist. Die Durchgangsschlitze entstehen durch streckende Verformung eines Metallbleches in das vorher entsprechende Schnitte eingebracht wurden. Eine derartige Sonnenschutzvorrichtung ist bspw. auch in der US 3 453 039 in Verbindung mit den Figuren 3 und 4 dieser Druckschrift kurz angesprochen, die sich mit einer Sonnenschutzvorrichtung ohne durchgängige Öffnungen befasst.

Weiterhin sind kommerziell Verglasungen mit Sonnenschutzfunktion erhältlich, die mit einem Siebdruckmuster oder mit einem Muster aus Dünnschichtsolarzellen beschichtet sind, wobei zwischen den opak oder transluzent bedruckten Bereichen Lichtdurchgangsöffnungen vorhanden sind, durch die eine Durchsicht möglich ist. Derartige Verglasungen ermöglichen jedoch keine winkelselektive Transmission der Sonnenstrahlung.

Die DE 196 11 060 A1 offenbart eine Sonnen- und Blendschutzvorrichtung, die die Möglichkeit der Regelung der Intensität des eingestrahlten Lichts bietet. Diese Sonnen- und Blendschutzvorrichtung weist zwei gegeneinander verschiebbare Scheiben oder Platten auf, die jeweils an der der anderen Scheibe oder Platte zugewandten Seite mit einer Strukturschicht aus einem optisch nicht transparenten Material versehen sind, wobei die beiden Strukturschichten unter Bildung von Lichtdurchgangsöffnungen und lichtundurchlässigen Bereichen strukturiert sind. Durch Verschieben der beiden Scheiben oder Platten wird der Anteil der Fläche, bei der eine Lichtdurchgangsöffnung durch den lichtundurchlässigen Bereich der anderen Scheibe überdeckt wird, kontinuierlich verändert. Auf diese Weise kann der Lichtdurchlass zwischen einem maximalen und einem minimalen Lichtdurchlass eingestellt werden. Über die Breite des mit Luft gefüllten Zwischenraumes zwischen den beiden Scheiben bzw. Strukturschichten kann der Anteil an diffusem Licht im Verhältnis zu direkt einstrahlendem Licht vorgewählt werden.

Die EP 0 170 472 A2 offenbart eine transparente oder transluzente Scheibe, auf der auf einer Seite ein Design aufgebracht ist, das von der anderen Seite nicht sichtbar sein soll. Auch auf eine zusätzliche Sonnenschutzfunktion mit ersten und zweiten bspw. als horizontale Streifen ausgebildeten opaken Strukturelementen wird in dieser Druckschrift verwiesen. Diese Strukturelemente können dabei auch durch Solarzellen gebildet sein.

**Darstellung der Erfindung**

Die Aufgabe der vorliegenden Erfindung besteht darin, eine Sonnenschutzvorrichtung anzugeben, die eine winkelselektive Transmission optischer Strahlung, insbesondere von einfallender Sonnenstrahlung, ermöglicht und ohne bewegliche Teile auskommt.

Die Aufgabe wird mit der Sonnenschutzvorrichtung gemäß Patentanspruch 1 gelöst. Vorteilhafte Ausgestaltungen der Sonnenschutzvorrichtung sind Gegenstand der Unteransprüche oder lassen sich der nachfolgenden Beschreibung sowie den Ausführungsbeispielen entnehmen.

Die vorgeschlagene Sonnenschutzvorrichtung umfasst wenigstens eine erste Strukturschicht aus einem optisch opaken oder nur teilweise lichtdurchlässigen Material auf einer optisch transparenten dielektrischen, d. h. optisch brechenden, Schicht oder Schichtfolge zumindest annähernd konstanter Dicke und eine zweite Strukturschicht aus einem optisch opaken oder nur teilweise lichtdurchlässigen Material, wobei die erste und die zweite Strukturschicht unter Bildung von Lichtdurchgangsöffnungen oder Lichtdurchgangsbereichen und lichtundurchlässigen oder lichtschwächenden Bereichen strukturiert sind. Unter einem nur teilweise lichtdurchlässigen Material wird dabei ein transparentes oder transluzentes Material verstanden, mit dem die Strukturschicht in der gewählten Schichtdicke einen Lichttransmissionsgrad von ≤ 40%, vorzugsweise ≤ 10 %, besonders bevorzugt ≤ 3%, für die einfallende Strahlung aufweist. Dies wird durch Wahl eines Materials erreicht, das die einfallende Strahlung zu einem ausreichenden Prozentsatz reflektiert und/oder absorbiert.

Bei der vorgeschlagenen Sonnenschutzvorrichtung ist die zweite Strukturschicht auf einer der ersten Strukturschicht gegenüber liegenden Seite der optisch transparenten Schicht oder Schichtfolge in direktem Kontakt mit der optisch transparenten Schicht oder Schichtfolge mit dieser verbunden. Die beiden damit fest bzw. statisch zueinander angeordneten Strukturschichten sind derart strukturiert, dass unter einem vorgegebenen Winkelbereich auf die zweite Strukturschicht auftreffende optische Strahlung durch Zusammenwirkung der beiden Strukturschichten blockiert oder zumindest - bei Verwendung eines nur teilweise lichtdurchlässigen Materials - entsprechend abgeschwächt wird und ein Anteil optischer Strahlung, der unter einem anderen Winkelbereich auf die zweite Strukturschicht auftrifft, die Strukturschichten über die Lichtdurchgangsöffnungen oder -bereiche ungehindert passieren kann. Die Winkelbereiche sind dabei in einer Bezugsebene definiert, die senkrecht zur zweiten Strukturschicht liegt, d. h. senkrecht zu der zur Seite der einfallenden Strahlung gerichteten Oberfläche der Sonnenschutzvorrichtung. Die zweite Strukturschicht stellt dabei die nach außen, d.h. zum Sonnenlicht, gewandte Schicht der Sonnenschutzvorrichtung dar.

Die lichtundurchlässigen Bereiche der zweiten Strukturschicht sind aus Solarzellen gebildet, wobei die zur zweiten Strukturschicht gerichtete Innenseite der ersten Strukturschicht reflektierend ausgeführt ist, so dass die zweite Strukturschicht durch auf die Innenseite der ersten Strukturschicht auffallende optische Strahlung indirekt beleuchtet wird.

Mit der vorgeschlagenen Sonnenschutzvorrichtung kann gleichzeitig Sonnenschutz, Durchsicht und - für die meisten Sonnenstände - auch Blendschutz erreicht werden. Die statische Sonnenschutzvorrichtung kommt vollständig ohne gegeneinander bewegliche Komponenten aus. Die winkelselektive Transmission wird alleine durch geeignete Dimensionierung der beiden Strukturschichten in Zusammenwirkung mit der zwischenliegenden Licht brechenden Schicht oder Schichtfolge erreicht, mit der die Strukturschichten verbunden sind. Erst durch dieses lichtbrechende Medium zwischen den beiden Strukturschichten kann eine ausreichende Blendschutzwirkung für Sonnenstrahlung bei gleichzeitig ungehindertem Durchblick nach unten über die Dimensionierung der Strukturschichten erreicht werden.

In der einfachsten Ausgestaltung setzt sich die Sonnenschutzvorrichtung aus der optisch transparenten Schicht oder Schichtfolge mit den beidseitig aufgebrachten Strukturschichten zusammen. Die transparente Schicht oder Schichtfolge kann dabei, wie auch bei allen nachfolgenden Ausgestaltungen, durch eine Scheibe aus einem transparenten Glas- oder Kunststoffmaterial (bspw. Acrylglas oder Polykarbonat) gebildet sein. Die Strukturen der beiden Strukturschichten bilden ein Streifenmuster aus parallelen Streifen aus dem opaken oder nur teilweise lichtdurchlässigen Material. Die Strukturen der beiden Strukturschichten weisen dabei die gleiche Periodizität auf. Sie können bspw. mit einer Siebdrucktechnik aufgebracht sein. Auch die Nutzung von Klebestreifen ist für die erste Strukturschicht möglich, wobei dann bevorzugt Streifen aus Metall oder Kunststoff eingesetzt werden. Zur verbesserten Aufbringung von Klebestreifen können diese an bestimmten Stellen über dünne Stege miteinander verbunden sein, so dass der Abstand der Streifen beim Prozess des Aufbringens bzw. Aufklebens ausreichend fixiert ist.

Die lichtundurchlässigen Bereiche der zweiten Strukturschicht sind durch Photovoltaik-Solarzellen gebildet. Hierfür eignen sich besonders amorphe Solarzellen.

Die Streifen der ersten Strukturschicht können innen und außen unterschiedliche Farben haben, wobei mit außen die im bestimmungsgemäßen Gebrauch der Sonnenschutzvorrichtung zur Strahlung gerichtete Seite, bspw. die Außenseite eines Fassadenelementes oder Fensters, und mit innen die der Strahlung abgewandte Seite, d. h. bspw. die Innenseite eines Fassadenelements oder Fensters, bezeichnet ist. Die Erzielung unterschiedlicher Farben lässt sich bspw. bei Aufbringung der Schichtstrukturen mittels Siebdruck durch Doppeldruck erreichen. Dabei wird zunächst die von der einen Seite sichtbare Farbe aufgedruckt und dann darüber die von der Rückseite sichtbare Farbe. Die Technik des Doppeldrucks ist bekannt und wird bei Siebdruckscheiben bereits eingesetzt. Bei der bestimmungsgemäßen Anwendung der vorgeschlagenen Sonnenschutzvorrichtung ist es dabei sinnvoll, wenn der Siebdruck nach außen aus Sonnenschutzgründen hoch reflektierend ist, bspw. weiß, und nach innen aus Blendschutzgründen dunkler, bspw. lichtgrau. Durch Doppeldruck lässt sich eine mit der Sonnenschutzvorrichtung verkleidete Fassade nach außen beliebig gestalten, ohne den Nutzer zu stören. In dem beispielhaften Fall wird durch eine weiße Außenseite der ersten Strukturschicht die Innenseite der äußeren (zweiten) Strukturschicht indirekt beleuchtet. Das wirkt sich positiv auf die Tageslichtversorgung für einen Innenraum aus, wenn die Rückseite der äußeren Strukturschicht nicht zu dunkel ausgeführt ist. Hier kann ein Kompromiss zwischen Blendschutz/Durchsicht (= dunkle Rückseite) und Tageslichtversorgung (= helle Rückseite) gefunden werden.

In einer Weiterbildung der vorgeschlagenen Sonnenschutzvorrichtung, insbesondere bei Einsatz amorpher Solarzellen in der zweiten Strukturschicht, ist die zweite Strukturschicht auf der der optisch transparenten Schicht oder Schichtfolge gegenüber liegenden Seite mit einer zweiten optisch transparenten Schicht oder Schichtfolge verbunden. Auch diese zweite optisch transparente Schicht oder Schichtfolge ist vorzugsweise eine Glas- oder Kunststoffscheibe.

In diesem Fall können die Strukturen bzw. Streifen der zweiten Strukturschicht dann bei der Herstellung zunächst auf diese zweite transparente Schicht oder Schichtfolge aufgebracht werden, bspw. mittels Siebdruck, bevor die Verbindung mit der ersten transparenten Schicht- oder Schichtfolge erfolgt. Der gesamte Aufbau ist dabei vorzugsweise als Verbundglasscheibe realisiert, bei dem die beiden Glas- oder Kunststoffscheiben mit der zwischenliegenden zweiten Strukturschicht über eine Klebefolie (z.B. PVB-Folie) miteinander verbunden werden. Die Klebefolie sollte hierbei einen Brechungsindex aufweisen, der nahe am Brechungsindex des verwendeten Glas- oder Kunststoffmaterials der beiden Scheiben liegt, um zusätzliche größere Brechungseffekte für die optische Strahlung zu vermeiden. Selbstverständlich ist auch der Einsatz anderer Verbindungstechniken möglich, beispielsweise durch Einsatz eines viskosen Klebers.

Bei der vorgeschlagenen Sonnenschutzvorrichtung lassen sich auch auf der Innenseite, d. h. auf der noch freien Seite der ersten Strukturschicht, weitere optisch transparente Schichten oder Schichtfolgen anbringen. Hier ist auch die Verwendung von Schichten mit bestimmter Farbe möglich, um ästhetischen Ansprüchen Rechnung zu tragen. Diese innere Schicht oder Schichtfolge, in der vorliegenden Patentanmeldung als dritte Schicht oder Schichtfolge bezeichnet, hat keine weitere Abschattungsfunktion. Sie kann ebenfalls aus einer Glas- oder Kunststoffscheibe, ggf. mit zusätzlicher Beschichtung, gebildet sein. In diesem Fall ist die Sonnenschutzvorrichtung vorzugsweise als Verbundglasscheibe mit drei Glas- oder Kunststoffscheiben realisiert, die über Klebefolien miteinander verbunden sind und zwischen denen die Strukturschichten liegen.

Auch die Ausgestaltung der vorgeschlagenen Sonnenschutzvorrichtung als Isolierverglasung oder als Mehrfachverglasung (z.B. Doppelverglasung oder Dreifachverglasung) ist möglich. Im Falle der Doppelverglasung bildet die aus den beiden Strukturschichten und den ein oder mehreren optisch transparenten Schichten oder Schichtfolgen aufgebaute Komponente vorzugsweise die äußere Scheibe der Doppelverglasung. Auch eine Nutzung als innere Scheibe - oder im Falle von mehr als zwei Scheiben als Zwischenscheibe - ist selbstverständlich möglich. Zwischen diesem äußeren Verglasungselement und einem inneren Verglasungselement, einer Glas- oder Kunststoffscheibe, ist ein mit Gas oder einer Gasmischung gefüllter Zwischenraum vorhanden, der vorzugsweise hermetisch abgeschlossen ist. Als Gas oder Gasmischung kommen hierbei in bekannter Weise bspw. Luft, Argon oder Krypton in Betracht. Die an diesen Zwischenraum grenzende Seite des äußeren Verglasungselementes oder die an diesen Zwischenraum grenzende Seite des inneren Verglasungselementes kann dabei zusätzlich beschichtet sein, bspw. mit einer Wärmeschutzbeschichtung (z.B. Low-E Soft-Coating).

Die vorgeschlagene Sonnenschutzvorrichtung lässt sich generell als Verglasungselement für alle Fassadenbereiche einsetzen, die verglast werden sollen. Bevorzugt wird die Sonnenschutzvorrichtung in Bereichen eingesetzt, die nicht unmittelbar zur Aussicht dienen. Weiterhin bieten sich insbesondere Brüstungsbereiche von Glasfassaden oder Balkonbrüstungen sowohl im Wohnungs- als auch im Nichtwohnungsbau als Anwendungsfelder an. Durch Verwendung von Dünnschichtsolarzellen für die lichtundurchlässigen Bereiche der zweiten Strukturschicht wird eine Optimierung der Eigenschaften von Verglasungen mit Dünnschicht-Solarzellen erreicht.

Die Sonnenschutzvorrichtung lässt sich unter Verwendung der üblichen Fertigungstechnologien des Fenster- und Fassadenbaus in Form einer aus einer oder mehreren der transparenten Schichten bestehenden Einzelscheibe oder als Isolier- oder Mehrfachverglasung herstellen.

Die Streifen der beiden Strukturschichten sind bei der vorgeschlagenen Sonnenschutzvorrichtung so dimensioniert, dass beim Einsatz dieser Sonnenschutzvorrichtung von oben einfallendes Sonnenlicht durch die lichtundurchlässigen oder nur teilweise lichtdurchlässigen Streifen der beiden Strukturschichten blockiert oder zumindest um $\geq 60\%$, vorzugsweise um $\geq 90\%$, besonders bevorzugt um $\geq 97\%$, abgeschwächt wird, während der direkte Durchblick nach unten weiterhin gewährleistet ist. Die lichtundurchlässigen oder nur teilweise lichtdurchlässigen Bereiche der zweiten Strukturschicht nehmen dabei insgesamt eine kleinere Fläche auf der optisch transparenten Schicht oder Schichtfolge ein als die lichtundurchlässigen oder nur teilweise lichtdurchlässigen Bereiche der ersten Strukturschicht. Durch die Breite, den Abstand und den gegenseitigen Versatz der Streifen der beiden Strukturschichten lassen sich die Winkelbereiche der einfallenden Sonnenstrahlung festlegen, die nicht oder zumindest stark geschwächt durch die Sonnenschutzvorrichtung gelangen, und die Winkelbereiche einstellen, in denen ein Anteil der Strahlung ungehindert durch die Sonnenschutzvorrichtung gelangen kann. Die vier Freiheitsgrade für die Geometrie dieser Strukturschichten lassen sich durch Spezifikation von Bereichen für vier Winkel $\alpha$, $\beta$, $\gamma$, und $\sigma$ angeben, wie dies in den nachfolgenden Ausführungsbeispielen näher erläutert ist. Die Winkelbereiche beziehen sich auf die Bezugsebene und sind relativ zur Flächennormale auf die Schichten der Sonnenschutzvorrichtung angegeben.

Beim Einsatz der Sonnenschutzvorrichtung hängt die geeignete Dimensionierung und Ausrichtung der Streifen auch von der Orientierung der Sonnenschutzvorrichtung bzw. der Seite des Bauwerks ab, an der die Sonnenschutzvorrichtung eingesetzt wird. Bei senkrechten Fassaden, d. h. bei senkrechter Aufstellung der Sonnenschutzvorrichtung stellt die Flächennormale der Sonnenschutzvorrichtung auch die Horizontale dar, gegenüber der der maßgebliche Profilwinkel der Sonne definiert ist. Bei nicht senkrecht stehenden, d. h. geneigten Fassaden, ergibt sich eine durch die Neigung bedingte Abweichung, die jedoch der Fachmann ohne Weiteres bei der Dimensionierung der vorliegenden Sonnenschutzvorrichtung berücksichtigen kann.

Für eine optimale Schutzwirkung können die Streifen beim Einsatz der Sonnenschutzvorrichtung auch schräg zur Horizontalen verlaufen, wenn die Flächennormale der Sonnenschutzvorrichtung bzw. Fassade nicht genau in Richtung Süden ausgerichtet ist. Je stärker die Fassadenorientierung von der Südrichtung abweicht, desto stärker können auch die Streifen gegenüber der Horizontalen geneigt sein. Die Streifen sind daher an einer vertikalen Südfassade bevorzugt horizontal ausgerichtet, während sie an nicht nach Süden orientierten Fassaden aus der Horizontalen entsprechend stark gedreht sind.

In einer Ausgestaltung der Sonnenschutzvorrichtung, bei der die erste Strukturschicht aus einem nur teilweise lichtdurchlässigen Material gebildet ist, wird vorzugsweise ein dunkles, im Wesentlichen klares durchsichtiges Material gewählt, das einen gerichtet diffusen Transmissionsgrad aufweist, der weniger als 20% des gesamten Transmissionsgrades des Materials ausmacht. Ein Beispiel hierfür ist ein Folienmaterial mit einem Gesamt-Transmissionsgrad von 2%. Auf diese Weise kann noch ein in vielen Fällen ausreichender Blendschutz bei gleichzeitiger geringer Durchsicht nach oben erreicht werden.

In einer weiteren Ausgestaltung wird für die erste Strukturschicht ein im Transmissionsgrad schaltbares Material eingesetzt, z.B. ein elektrochromes oder ein gaschromes Material. Bei einem derartigen Material lässt sich der Transmissionsgrad in einem weiten Bereich, bspw. im Bereich zwischen 1% und 70%, steuern.

## Kurze Beschreibung der Zeichnungen

Die vorgeschlagene Sonnenschutzvorrichtung wird nachfolgend anhand von Ausführungsbeispielen in Verbindung mit den Zeichnungen nochmals näher erläutert. Hierbei zeigen:

Fig. 1    ein erstes Beispiel für eine Ausgestaltung der Sonnenschutzvorrichtung;

Fig. 2    das Beispiel der Figur 1 mit allgemeinen Winkelangaben;

Fig. 3    ein zweites Beispiel für eine Ausgestaltung der Sonnenschutzvorrichtung;

Fig.4    ein drittes Beispiel für eine Ausgestaltung der Sonnenschutzvorrichtung;

Fig. 5    ein viertes Beispiel für eine Ausgestaltung der Sonnenschutzvorrichtung; und

Fig. 6    ein Beispiel für unterschiedliche Orientierungen der Streifen der Sonnenschutzvorrichtung bei unterschiedlicher Ausrichtung der Fassade.

## Wege zur Ausführung der Erfindung

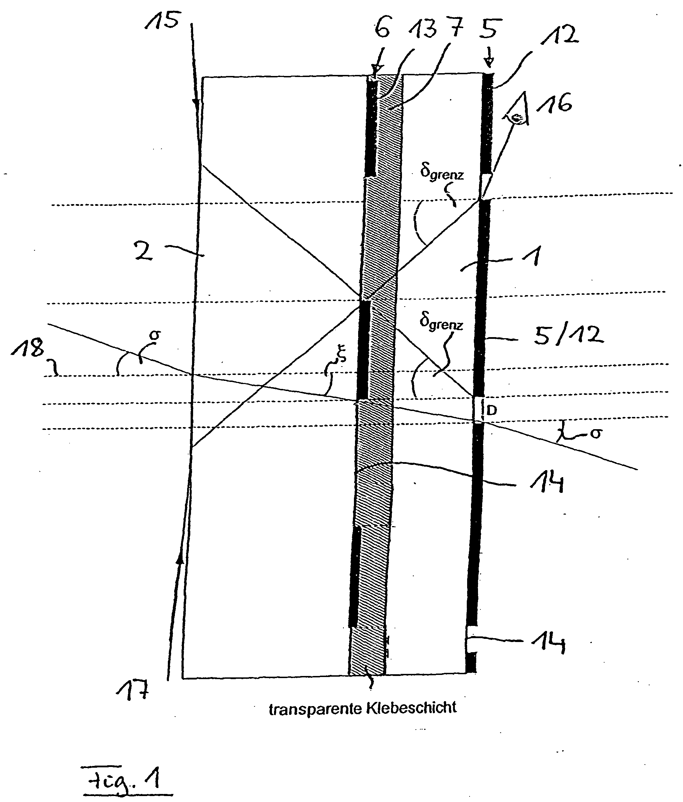

Die Figur 1 zeigt in einem Ausschnitt eine Schnittdarstellung einer beispielhaften Sonnenschutzvorrichtung gemäß der vorliegenden Erfindung, wie sie als Verglasung oder Fassadenelement eingesetzt werden kann. Bei diesem Beispiel wurde eine vertikale Fassade angenommen, an der die Sonnenschutzvorrichtung angebracht ist.

Die Sonnenschutzvorrichtung weist in diesem Beispiel eine erste optisch transparente Schichtfolge aus einer Glasscheibe 1 und einer Verklebungsfolie 7 auf. Die Glasscheibe 1 ist auf der Innenseite mit einer ersten Strukturschicht 5 und auf der Außenseite über die Verklebungsfolie 7 mit einer zweiten Strukturschicht 6 verbunden. Auf der zweiten Strukturschicht 6 ist eine zweite transparente Schicht 2 angeordnet, die die Außenseite der Sonnenschutzvorrichtung bildet und bspw. ebenfalls eine Glasscheibe sein kann. Die in der Sonnenschutzvorrichtung eingebettete zweite Strukturschicht 6 setzt sich aus einem Streifenmuster aus lichtundurchlässigen Streifen 13 zusammen, zwischen denen Lichtdurchgangsöffnungen 14 als ebenfalls parallel verlaufende Schlitze ausgebildet sind. Auch die die Innenseite der Sonnenschutzvorrichtung bildende erste Strukturschicht 5 setzt sich aus entsprechenden Streifen 12 und Lichtdurchgangsöffnungen 14 zusammen. In der Figur ist hierbei jeweils nur die Breite der Streifen 12, 13 zu erkennen, wobei sich die Streifen in Richtung senkrecht zur Zeichnungsebene erstrecken.

Bei der Dimensionierung der Streifen 12, 13 der beiden Strukturschichten 5, 6 der Sonnenschutzvorrichtung kann von oben einfallendes Licht 15 nicht durch die Sonnenschutzvorrichtung in den Innenraum eindringen, auch nicht wenn es streifend einfällt. Dies ist anhand des in der Figur 1 dargestellten Strahlverlaufes angedeutet. Ein Beobachter 16 hat dennoch von Innen eine komplett freie Sicht durch die Sonnenschutzvorrichtung von der Horizontalen bis nach unten, wie ebenfalls in der Figur 1 angedeutet ist. Quasi streifend einfallendes Licht 17 verläuft in dem optisch transparenten Material der Sonnenschutzvorrichtung unter dem Grenzwinkel der Totalreflexion $\sigma_{Grenz}$. Sehr hoch stehende Sonne kann daher bei dieser Ausgestaltung nicht direkt in den Innenraum scheinen, weil das Licht flacher als $\sigma_{Grenz}$ durch das optisch transparente Material laufen würde. Für den Fall von Glasscheiben ($n \approx 1{,}55$) ergibt sich ein Grenzwinkel der Totalreflexion von 40-42°. Auf der anderen Seite kann ein unter dem Winkel $\sigma$ gegenüber der Flächennormale 18 einfallender Lichtstrahl gerade noch ungehindert passieren. Dies entspricht einer bereits sehr tief stehenden Sonne.

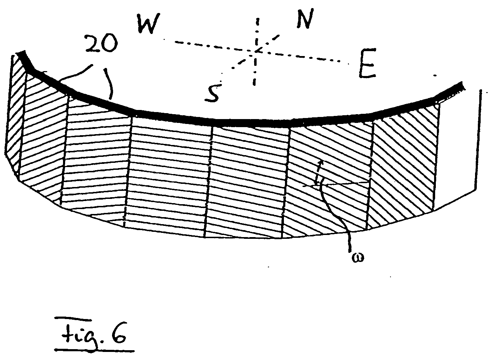

Die Flächennormale 18 entspricht bei dieser Ausgestaltung auch der Horizontalen. Dies ist jedoch bei nicht vertikal verlaufenden Fassaden bzw. nicht vertikaler Anordnung der Sonnenschutzvorrichtung nicht der Fall (vgl. z.B. Fig. 6).

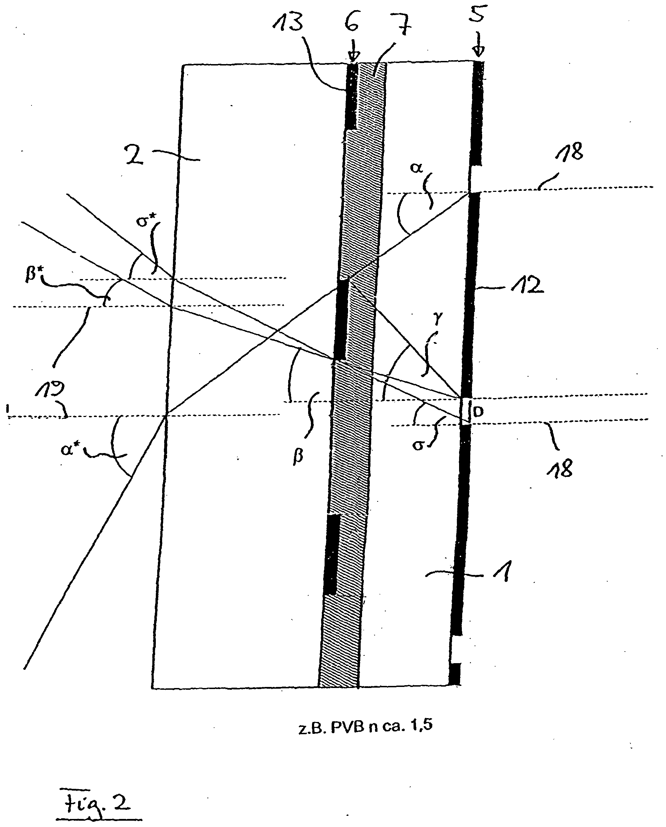

Figur 2 zeigt daher die für die Ausgestaltung der Sonnenschutzvorrichtung relevanten Winkel in allgemeiner Form. Der Aufbau der Sonnenschutzvorrichtung ist der Figur 2 ist identisch dem Aufbau der Sonnenschutzvorrichtung der Figur 1, wobei als Verklebungsfolie 7 PVB mit einem Brechungsindex von n = 1,5 eingesetzt wird. Die Sonne soll ab einem bestimmten Profilwinkel $\sigma_p$ ausgeblendet werden. Im vorliegenden Beispiel wird hierbei eine Südfassade angenommen, bei der die Streifen 12, 13 der Strukturschichten 5, 6 horizontal verlaufen. In der Darstellung der Figur 2 ist nur beispielhaft die Horizontale 19 parallel zur Flächennormale 18 eingezeichnet.

Die Winkel $\alpha^*$, $\beta^*$ und $\sigma^*$ werden gegen die Horizontale 19 gemessen, nicht gegen die Flächennormale 18 der Fassade bzw. Sonnenschutzvorrichtung. Die Winkel $\alpha$, $\beta$, $\gamma$ und $\sigma$ sind gegen die Flächennormale 18 definiert. Bei geneigten Fassaden (z.B. Dachverglasung) stimmen die Flächennormale 18 und die Horizontale 19 nicht überein. Sämtliche Winkel beziehen sich auf eine senkrecht zu den Schichtebenen der einzelnen Schichten bzw. zur Oberfläche der Sonnenschutzvorrichtung orientierte Bezugsebene, in den vorliegenden Beispielen die Zeichnungs- bzw. Blattebene. Bei nicht in dieser Bezugsebene einfallender Sonnenstrahlung gelten die Winkelangaben für die Projektion des Strahlungsvektors in die Bezugsebene (Profilwinkel).

Die vier Winkel $\alpha$, $\beta$, $\gamma$ und $\sigma$ sind jeweils zur Flächennormale 18 der Sonnenschutzvorrichtung definiert. Die Winkel $\alpha$ und $\gamma$ spezifizieren die Lage der Oberkante des jeweiligen Streifens der zweiten Strukturschicht 6 gegenüber den beiden Streifenkanten des jeweils nächstliegenden Streifens der ersten Strukturschicht 5. Der Winkel $\beta$ definiert die Neigung der Verbindungslinie zwischen den Unterkanten der nächstliegenden Streifen der ersten 5 und zweiten Strukturschicht 6, der Winkel $\sigma$ die Neigung der Verbindungslinie zwischen der Unterkante der Streifen der zweiten Strukturschicht 6 und der Oberkante des jeweils darunter liegenden Streifens der ersten Strukturschicht 5 (vgl. Fig. 2).

Die Winkel $\alpha^*$, $\beta^*$, $\gamma^*$ und $\sigma^*$ ergeben sich mit Hilfe des Brechungsgesetztes aus den Winkeln $\alpha$, $\beta$, $\gamma$ und $\sigma$ (oder umgekehrt) in der folgenden allgemeinen Form:

$$\sin(\xi^*)/\sin(\xi) = n_{Material}/n_{Umgebung}.$$

Dabei wurde angenommen, dass der Brechungsindex der Verklebungsschicht 7 sehr gut mit dem Brechungsindex des Glases übereinstimmt. Wenn das nicht der Fall ist, müssen die weiteren Brechungen an den Grenzflächen berücksichtigt werden. Dies ist jedoch in einfacher Weise mit dem Brechungsgesetz möglich. Bei Mikrostrukturen, d.h. Mikrostreifen, gilt das Brechungsgesetz aufgrund der Beugungserscheinungen nicht ohne weiteres. Die hier vorgeschlagenen Strukturen lassen sich aber dennoch einsetzen. In diesem Fall muss dann der Grenzwinkel $\sigma_{Grenz}$ der Totalreflexion etwas größer angenommen werden als er sich aus der geometrischen Optik ergibt, damit dennoch eine ausreichende Ausblendung der Sonnenstrahlung gewährleistet ist.

Der Winkel $\beta^*$ gibt an, ab welchem Winkel die Sonne durch streifenden Einfall an den Streifen der Schichtstrukturen durch die Sonnenschutzvorrichtung dringen kann.

Der Winkel $\beta$ sollte so eingestellt werden, dass sich aufgrund des Brechungsgesetzes folgende Winkel für $\beta^*$ ergeben: $-20° \leq \beta^* \leq 20°$, besonders bevorzugt $-10° \leq \beta^* \leq 0°$. Varianten mit $60° > |\beta^*| > 20°$ sind ebenfalls möglich. Hierbei handelt es sich jedoch um verschlechterte Ausführungsformen. Die Winkelangaben für $\beta^*$ gelten unabhängig von der Neigung der Fassade. Sie leiten sich alleine aus den möglichen Sonnenpositionen ab.

Der Winkel $\alpha$ sollte so eingestellt werden, dass sich aufgrund des Brechungsgesetztes folgende Bereiche für $\alpha^*$ einstellen: $-20° \leq \alpha^* \leq 90°$, bevorzugt $0° \leq \alpha^* \leq 90°$, besonders bevorzugt $45° \leq \alpha^* \leq 90°$. $\alpha$ ist dann automatisch kleiner als $\sigma_{Grenz}$. Optimal liegt $\alpha^*$ bei 90°, d. h. $\alpha = \sigma_{Grenz}$.

Für den Winkel $\gamma$ werden vorzugsweise folgende Bereiche gewählt: $-30° \leq \gamma \leq 80°$, bevorzugt $\sigma_{Grenz} \leq \gamma \leq 80°$, besonders bevorzugt $\sigma_{Grenz} \leq \gamma \leq \sigma_{Grenz} +20°$. Im optimalen Fall stimmt $\gamma$ mit $\sigma_{Grenz}$ überein.

Varianten, bei denen $\alpha$ größer als $\sigma_{Grenz}$ ist, sind verschlechterte Ausführungsformen, weil dann die Spalte bzw. Schlitze der ersten Strukturschicht weiter unten liegen müssen, damit kein Licht von oben durchscheinen kann. Dies hat einen kleineren Flächenanteil der freien Fläche auf der Innenseite zur Folge und bewirkt damit eine schlechtere Transparenz. Varianten, bei denen $\gamma$ kleiner als $\sigma_{Grenz}$ ist, sind ebenfalls verschlechterte Ausführungsformen, da die Sonne von oben durch das Element scheinen kann.

Der Abstand D der Strukturelemente bzw. Streifen der ersten Schichtstruktur sollte unabhängig von der Neigung der Fassade so gewählt werden, dass die direkte Sonne ab einem Profilwinkel $\sigma_p$ von $-20° \leq \sigma_p = \sigma^* \leq 70°$, bevorzugt $0° \leq \sigma_p = \sigma^* \leq 45°$, besonders bevorzugt $5° \leq \sigma_p = \sigma^* \leq 25°$ ausgeblendet wird. Dies erfordert ebenso wie die Dimensionierung auf Basis der Winkel $\alpha^*$, $\beta^*$ und $\gamma^*$ die Kenntnis der Neigung der Fassade, an der die Sonnenschutzvorrichtung eingesetzt werden soll.

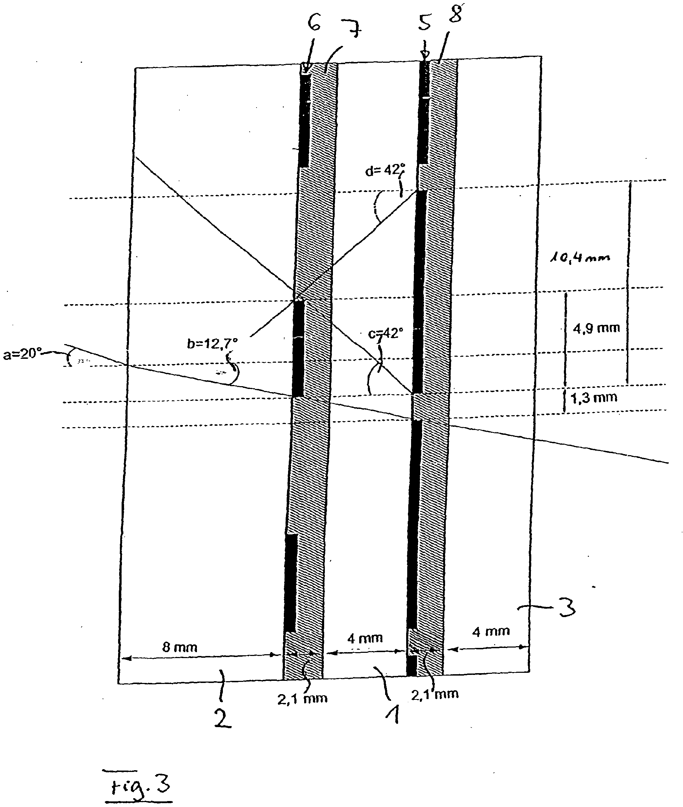

Figur 3 zeigt ein weiteres Beispiel für eine Ausgestaltungsmöglichkeit der vorliegenden Sonnenschutzvorrichtung. Im Unterschied zu den Figuren 1 und 2 ist bei dieser Ausgestaltung eine weitere optisch transparente Schichtfolge an der Innenseite angebracht. Diese dritte transparente Schichtfolge setzt sich im vorliegenden Beispiel aus einer Glasscheibe 3 und einer Verklebungsfolie 8 zusammen, bspw. aus PVB. Figur 3 zeigt somit eine 3-fach VSG-Scheibe (Verbundglasscheibe), in der die Strukturschichten 5, 6 vollkommen eingeschlossen sind.

In dem Beispiel der Figur 3 wurde die Optimalform der Strukturen bzw. Streifen für den Fall von Glasscheiben mit n = 1,5 als optisch transparente Schichten bemaßt. Die beispielhaften Maße und Winkel sind der Figur entnehmbar. Im Falle einer anderen Dicke der mittleren Glasscheibe 1 verändert sich die Höhe und der Abstand der Streifen 12, 13 entsprechend. Die Winkel bleiben gleich.

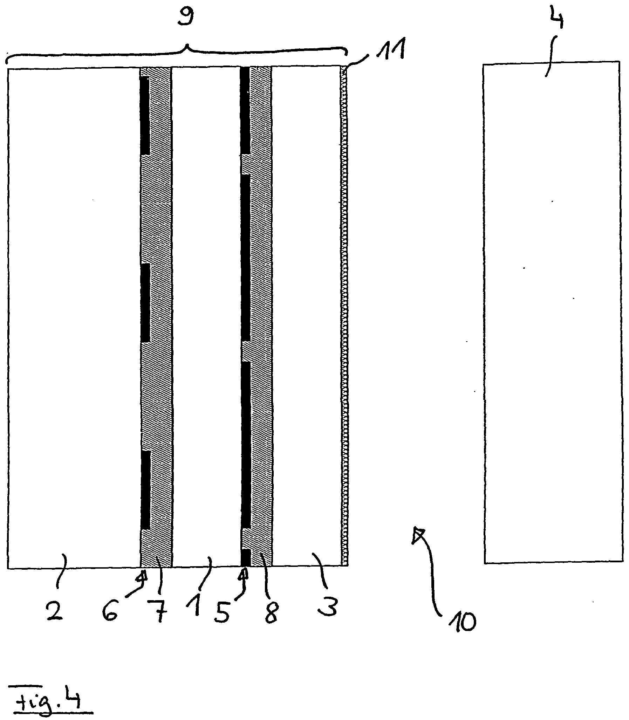

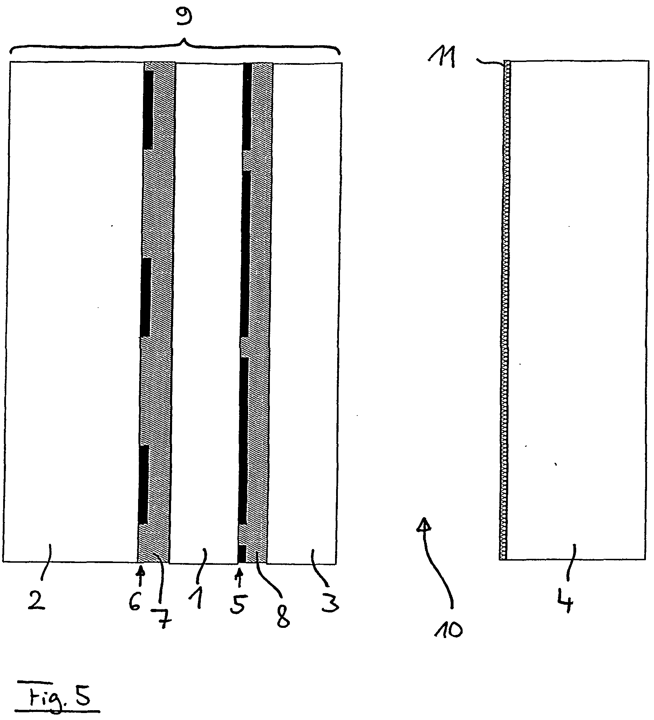

Die Figuren 4 und 5 zeigen schließlich Ausgestaltungsmöglichkeiten der Sonnenschutzvorrichtung, bei der diese in einer Doppelverglasung eingesetzt wird. Hierzu bildet die Schichtfolge mit den transparenten Schichten bzw. Scheiben 1 bis 3 und den Strukturschichten 5 und 6 ein äußeres Verglasungselement 9 der Doppelverglasung. Zwischen dem inneren Verglasungselement 4, einer Glasscheibe, und dem äußeren Verglasungselement 9 ist ein hermetisch geschlossener Zwischenraum 10 ausgebildet, der bspw. eine Dicke von 16 mm aufweisen und mit Argon gefüllt sein kann. Im Beispiel der Figur 4 ist die Innenseite des äußeren Verglasungselementes 9 mit einer zusätzlichen Beschichtung 11, bspw. mit einer Wärmeschutzbeschichtung (z.B. Low-E Soft-Coating), versehen.

Die Ausgestaltung der Figur 5 zeigt demgegenüber den gleichen Aufbau der Doppelverglasung, wobei hier jedoch die Beschichtung 11 auf der Außenseite des zweiten, inneren Verglasungselementes 4 vorgesehen ist. Diese Anordnung der Beschichtung 11 lässt sich kostengünstiger realisieren, da die Aufbringung auf konventionelle Glasscheiben einen Standardprozess darstellt. Bei einer anschließenden Laminierung, wie dies für das äußere Verglasungselement erforderlich ist, besteht die Gefahr einer Beschädigung der Beschichtung. Eine nachträglich auf das äußere Verglasungselement aufgebrachte Beschichtung erfordert wiederum einen speziellen Prozess für die speziell hergestellten äußeren Verglasungselemente und ist somit nicht so kostengünstig verfügbar wie eine herkömmliche Glasscheibe mit dieser Beschichtung.

An nicht nach Süden orientierten Fassaden sollten die Streifen 12, 13 der beiden Strukturschichten 5, 6 aus der Vertikalen bzw. Horizontalen gedreht sein, wie dies anhand der Figur 6 veranschaulicht ist (vgl. W. Lorenz, "A Glazing Unit for Solar Control, Day Lighting and Energy Conservation", Solar Energy Vol. 70, No. 2, pp. 109-130, 2001). In dieser Abbildung sind schematisch verschiedene Fassadenelemente 20 in unterschiedlicher Orientierung bzgl. der in der Figur angedeuteten Himmelsrichtungen beispielhaft nebeneinander dargestellt. Bei nicht exakt nach Süden orientieren Fassadenelementen wird eine Verdrehung der Streifen 12, 13 der Strukturschichten aus der Vertikalen bzw. Horizontalen bevorzugt, wie dies schematisch für die unterschiedlichen Orientierungen aus der Figur 6 ersichtlich ist.

Bevorzugt wird die gesamte Sonnenschutzvorrichtung so ausgestaltet, dass eine Durchsicht von Innen nach Außen unter den bestimmten Winkelbereichen, insbesondere nach unten, ermöglicht wird. Es ist jedoch auch möglich, eine oder mehrere der inneren Schichten nicht transparent sondern transluzent auszugestalten. Bei transluzenter Ausgestaltung dient die Struktur dann nur dem Blend- und Sonnenschutz. Licht kann von außen unten durch das Element gelangen.

Bezugszeichenliste

| 1 | Glasscheibe |
| 2 | zweite transparente Schicht |
| 3 | Glasscheibe |
| 4 | inneres Verglasungselement |
| 5 | erste Strukturschicht |
| 6 | zweite Strukturschicht |
| 7 | Verklebungsfolie |
| 8 | Verklebungsfolie |
| 9 | äußeres Verglasungselement |
| 10 | Zwischenraum |
| 11 | Beschichtung |
| 12 | Streifen der ersten Strukturschicht |
| 13 | Streifen der zweiten Strukturschicht |
| 14 | Lichtdurchgangsöffnungen |
| 15 | von oben einfallendes Licht |
| 16 | Beobachter |
| 17 | streifend von unten einfallendes Licht |
| 18 | Flächennormale |
| 19 | Horizontale |

20    Fassadenelement

**Patentansprüche**

**1.** Sonnenschutzvorrichtung, insbesondere Verglasung, die wenigstens eine erste Strukturschicht (5) aus einem opaken oder nur teilweise lichtdurchlässigen Material auf einer optisch transparenten dielektrischen Schicht oder Schichtfolge (1, 7) und eine zweite Strukturschicht (6) aus einem opaken oder nur teilweise lichtdurchlässigen Material umfasst, wobei die erste (5) und die zweite Strukturschicht (6) unter Bildung von Lichtdurchgangsöffnungen oder -bereichen (14) und lichtundurchlässigen oder lichtschwächenden Bereichen (12, 13) strukturiert sind, wobei die zweite Strukturschicht (6) auf einer der ersten Strukturschicht (5) gegenüberliegenden Seite der optisch transparenten Schicht oder Schichtfolge (1, 7) mit dieser verbunden ist und die beiden strukturierten Schichten (5, 6) derart strukturiert sind, dass unter einem vorgegebenen Winkelbereich, der in einer senkrecht zu der zweiten Strukturschicht (6) orientierten Bezugsebene definiert ist, auf die zweite Strukturschicht (6) auftreffende optische Strahlung durch Zusammenwirkung der beiden Strukturschichten (5, 6) blockiert oder abgeschwächt wird und ein Anteil optischer Strahlung, der unter einem anderen Winkelbereich in Bezug auf die gleiche Bezugsebene auf die zweite Strukturschicht (6) auftrifft, die Strukturschichten (5, 6) ungehindert passieren kann, wobei die lichtundurchlässigen Bereiche (13) der zweiten Strukturschicht (6) aus Solarzellen, insbesondere amorphen Solarzellen, gebildet sind, **dadurch gekennzeichnet,** **dass** eine zur zweiten Strukturschicht gerichtete Innenseite der ersten Strukturschicht reflektierend ausgeführt ist, so dass die zweite Strukturschicht durch auf die Innenseite der ersten Strukturschicht auffallende optische Strahlung indirekt beleuchtet wird.

**2.** Sonnenschutzvorrichtung nach Anspruch 1, **dadurch gekennzeichnet,** **dass** die zweite Strukturschicht (6) auf einer der optisch transparenten Schicht oder Schichtfolge (1, 7) gegenüberliegenden Seite mit einer zweiten optisch transparenten dielektrischen Schicht oder Schichtfolge (2), insbesondere mit einer Glas- oder Kunststoff-Scheibe, verbunden ist.

**3.** Sonnenschutzvorrichtung nach Anspruch 2, **dadurch gekennzeichnet,** **dass** die optisch transparente Schicht oder Schichtfolge (1, 7) eine Glas- oder Kunststoff-Scheibe (1) mit einer Klebefolie (7) umfasst, über die die Glas- oder Kunststoff-Scheibe (1) mit der zweiten Strukturschicht (6) und der Glas- oder Kunststoff-Scheibe der zweiten optisch transparenten Schicht oder Schichtfolge (2) fest verbunden ist.

**4.** Sonnenschutzvorrichtung nach einem der Ansprüche 1 bis 3, **dadurch gekennzeichnet,** **dass** die beiden strukturierten Schichten (5, 6) derart strukturiert sind, dass bei einer senkrechten Anordnung von oben einfallendes Licht blockiert oder abgeschwächt wird und von unten einfallendes Licht zu einem bestimmten Anteil passieren kann.

**5.** Sonnenschutzvorrichtung nach einem der Ansprüche 1 bis 4, **dadurch gekennzeichnet,** **dass** die lichtundurchlässigen oder lichtschwächenden Bereiche (13) der zweiten Strukturschicht (6) eine kleinere Fläche einnehmen als die lichtundurchlässigen oder lichtschwächenden Bereiche (12) der ersten Strukturschicht (5).

**6.** Sonnenschutzvorrichtung nach einem der Ansprüche 1 bis 5, **dadurch gekennzeichnet,** **dass** die die erste Strukturschicht (5) auf einer der optisch transparenten Schicht oder Schichtfolge (1, 7) gegenüberliegenden Seite mit einer dritten optisch transparenten dielektrischen Schicht oder Schichtfolge (3, 8) verbunden ist.

**7.** Sonnenschutzvorrichtung nach Anspruch 6, **dadurch gekennzeichnet,** **dass** die dritte optisch transparente Schicht oder Schichtfolge (3, 8) eine Glas- oder Kunststoff-Scheibe (3) umfasst, die über eine Klebefolie (8) mit der ersten Strukturschicht (5) und der optisch transparenten Schicht oder Schichtfolge (1, 7) verbunden ist.

**8.** Sonnenschutzvorrichtung nach einem der Ansprüche 1 bis 7, **dadurch gekennzeichnet,** **dass** die beiden Strukturschichten (5, 6) mit den mit ihnen verbundenen optisch transparenten Schichten oder Schichtfolgen ein äußeres Verglasungselement (9) einer Doppelverglasung bilden, bei der zwischen dem äußeren Verglasungselement (9) und einem inneren Verglasungselement (4) ein mit einem Gas oder einer Gasmischung gefüllter Zwischenraum (10) vorhanden ist.

9. Sonnenschutzvorrichtung nach Anspruch 8,
**dadurch gekennzeichnet,**
**dass** das innere Verglasungselement (4) auf einer zum Zwischenraum (10) gerichteten Seite mit einer Sonnen- oder Wärmeschutz-Beschichtung (11) versehen ist.

10. Sonnenschutzvorrichtung nach einem der Ansprüche 1 bis 9, **dadurch gekennzeichnet,**
**dass** die lichtundurchlässigen oder lichtschwächenden Bereiche (12, 13) der beiden Strukturschichten (5, 6) parallel zueinander verlaufende Streifen bilden.

11. Sonnenschutzvorrichtung nach Anspruch 10, **dadurch gekennzeichnet,**
**dass** gerade Verbindungslinien zwischen einander zugewandten Oberkanten jeweils nächstliegender Streifen der beiden Strukturschichten (5, 6) in der Bezugsebene ausgehend von der ersten Strukturschicht unter einem Winkel $\alpha$ zur Flächennormale (18) auf die Strukturschichten (5, 6) verlaufen, für den gilt: $-34° \leq \alpha \leq 60°$, vorzugsweise $0° \leq \alpha \leq 42°$, besonders bevorzugt $27° \leq \alpha \leq 42°$, optimal $\alpha = \sigma_{Grenz}$, wobei $\sigma_{Grenz}$ der Grenzwinkel der Totalreflexion ist,
**dass** gerade Verbindungslinien zwischen Oberkanten der Streifen der zweiten Strukturschicht (6) und Unterkanten der Streifen der ersten Strukturschicht (5) jeweils nächstliegender Streifen der beiden Strukturschichten (5, 6) in der Bezugsebene ausgehend von der ersten Strukturschicht (5) unter einem Winkel $\gamma$ zur Flächennormale (18) auf die Strukturschichten (5, 6) verlaufen, für den gilt: $-30° \leq \gamma \leq 80°$, vorzugsweise $\sigma_{Grenz} \leq \gamma \leq 80°$, besonders bevorzugt $\sigma_{Grenz} \leq \gamma \leq (\sigma_{Grenz} + 20°)$, optimal $\gamma = \sigma_{Grenz}$, wobei $\sigma_{Grenz}$ der Grenzwinkel der Totalreflexion ist, und
**dass** gerade Verbindungslinien zwischen einander zugewandten Unterkanten jeweils nächstliegender Streifen der beiden Strukturschichten (5, 6) in der Bezugsebene ausgehend von der ersten Strukturschicht (5) unter einem Winkel $\beta$ zur Flächennormale (18) auf die Strukturschichten (5, 6) verlaufen, für den gilt: $-34° \leq \beta \leq 60°$, vorzugsweise $-10° \leq \beta \leq 15°$, besonders bevorzugt $\beta = 0°$.

12. Sonnenschutzvorrichtung nach Anspruch 10,
**dadurch gekennzeichnet,**
**dass** bei Einsatz der Sonnenschutzvorrichtung in einer festgelegten Orientierung der Flächennormale zur Horizontalen (19) ein Abstand D zwischen Ober- und Unterkanten jeweils benachbarter Streifen der ersten Strukturschicht (5) so gewählt ist, dass Sonnenstrahlung ab einem Sonnenprofilwinkel $\sigma_p$ von $-20° \leq \sigma_p \leq 70°$, bevorzugt $0° \leq \sigma_p \leq 45°$, besonders bevorzugt $5° \leq \sigma_p \leq 25°$, durch Zusammenwirken der Strukturschichten (5, 6) blockiert wird.

13. Sonnenschutzvorrichtung nach einem der Ansprüche 10 bis 12, **dadurch gekennzeichnet,**
**dass** die erste (5) und/oder zweite Strukturschicht (6) aus einem Material gebildet sind, das eine Lichtdurchlässigkeit von $\leq 40\%$, vorzugsweise $\leq 10\%$, besonders bevorzugt $\leq 3\%$ aufweist.

14. Sonnenschutzvorrichtung nach Anspruch 13,
**dadurch gekennzeichnet,**
**dass** die erste (5) und/oder zweite Strukturschicht (6) aus einem Material gebildet sind, das einen gerichtet diffusen Transmissionsgrad aufweist, der weniger als 20% eines gesamten Transmissionsgrades des Materials ausmacht.

15. Sonnenschutzvorrichtung nach einem der Ansprüche 10 bis 14, **dadurch gekennzeichnet,**
**dass** die erste (5) und/oder zweite Strukturschicht (6) aus einem Material mit einem schaltbaren Transmissionsgrad, insbesondere einem elektrochromen oder gaschromen Material, gebildet sind.

## Claims

1. A sun protection device, more preferably glazing, which comprises a first structural layer (5) of an opaque or only partially translucent material on an optically transparent dielectric layer or layer sequence (1, 7) and a second structural layer (6) of an opaque or only partially translucent material, wherein the first (5) and the second structural layers (6) are structured subject to the formation of light passage openings or zones (14) and light-impermeable or light-weakening zones (12, 13),
wherein the second structural layer (6) on a side of the optically transparent layer or layer sequence (1, 7) which is opposite the first structural layer (5) is joined with said optically transparent layer or layer sequence and the two structured layers (5, 6) are structured in such a manner that under a predetermined angular range, which is defined in a reference plane orientated perpendicularly to the second structural layer (6), optical radiation incident on the second structural layer (6) is blocked or weakened through the interaction of the two structural layers (5, 6) and a proportion of optical radiation, which is incident on the second structural layer (6) under a different angular range with respect to the same reference plane, can pass the structural layers (5, 6) unhindered,

wherein the light-impermeable zones (13) of the second structural layer (6) are formed of solar cells, in particular amorphous solar cells,

**characterized in that**

an inner side of the first structural layer facing the second structural layer is formed to be reflective so that the second structural layer is indirectly illuminated by optical radiation incident on the inner side of the first structural layer.

2. The sun protection device according to Claim 1,
**characterized in that**
the second structural layer (6) on a side located opposite the optically transparent layer or layer sequence (1, 7) is joined with a second optically transparent dielectric layer or layer sequence (2), in particular with a glass or plastic pane.

3. The sun protection device according to Claim 2,
**characterized in that**
the optically transparent layer or layer sequence (1, 7) comprises a glass or plastic pane (1) with an adhesive film (7), via which the glass or plastic pane (1) is securely joined with the second structural layer (6) and the glass or plastic pane of the second optically transparent layer or layer sequence (2).

4. The sun protection device according to any one of the Claims 1 to 3,
**characterized in that**
the two structured layers (5, 6) are structured in such a manner that with a perpendicular arrangement incident light from above is blocked or weakened and incident light from below can pass at a certain proportion.

5. The sun protection device according to any one of the Claims 1 to 4,
**characterized in that**
the light-impermeable or light-weakening zones (13) of the second structural layer (6) take up a lesser area than the light-impermeable or light-weakening zones (12) of the first structural layer (5).

6. The sun protection device according to any one of the Claims 1 to 5,
**characterized in that**
the first structural layer (5) on a side opposite the optically transparent layer or layer sequence (1, 7) is joined with a third optically transparent dielectric layer or layer sequence (3, 8).

7. The sun protection device according to Claim 6,
**characterized in that**
the third optically transparent layer or layer sequence (3, 8) comprises a glass or plastic pane (3) which is joined with the first structural layer (5) and the optically transparent layer or layer sequence (1, 7) via an adhesive film (8).

8. The sun protection device according to any one of the Claims 1 to 7,
**characterized in that**
the two structural layers (5, 6) with the optically transparent layers or layer sequences joined to said structural layers form an outer glazing element (9) of a double glazing, wherein between the outer glazing element (9) and an inner glazing element (4) an intermediate space (10) filled with a gas or a gas mixture is present.

9. The sun protection device according to Claim 8,
**characterized in that**
the inner glazing element (4) on a side directed towards the intermediate space (10) is provided with a sun or heat protection coating (11).

10. The sun protection device according to any one of the Claims 1 to 9,
**characterized in that**
the light-impermeable or light-weakening zones (12, 13) of the two structural layers (5, 6) form strips which run parallel relative to one another.

**11.** The sun protection device according to Claim 10,
**characterized in that**
straight connecting lines between upper edges facing one another of the respectively nearest strips of the two structural layers (5, 6) run in the reference plane starting from the first structural layer at an angle $\alpha$ to the surface normal (18) to the structural layers (5, 6), for which the following applies: $-34° \leq \alpha \leq 60°$, preferentially $0° \leq \alpha \leq 42°$, particularly preferred $27° \leq \alpha \leq 42°$, optimally $\alpha = \sigma_{limit}$ wherein $\sigma_{limit}$ is the limit angle of the total reflection, that straight connecting lines between upper edges of the strips of the second structural layer (6) and lower edges of the strips of the first structural layer (5) in each case of nearest strips of the two structural layers (5, 6) run in the reference plane starting from the first structural layer (5) under an angle $\gamma$ to the surface normal (18) to the structural layers (5, 6), for which applies: $-30° \leq \gamma \leq 80°$, preferentially $\sigma_{limit} \leq \gamma \leq 80°$, particularly preferred $\sigma_{limit} \leq \gamma \leq (\sigma_{limit} + 20°)$, optimally $\gamma = \sigma_{limit}$ wherein $\sigma_{limit}$ is the limit angle of the total reflection, and that straight connecting lines between lower edges facing one another in each case of nearest strips of the two structural layers (5, 6) in the reference plane starting from the first structural layer (5) run under an angle $\beta$ to the surface normal (18) to the structural layers (5, 6), for which applies: $-34° \leq \beta \leq 60°$, preferentially $-10° \leq \beta \leq 15°$, particularly preferred $\beta = 0°$.

**12.** The sun protection device according to Claim 10,
**characterized in that**
when using the sun protection device in a fixed orientation of the surface normal to the horizontal (19) a distance D between upper and lower edges in each case of neighbouring strips of the first structural layer (5) are selected so that solar radiation from a solar profile angle $\sigma_p$, of $-20° \leq \sigma_p \leq 70°$, preferably $0° \leq \sigma_p \leq 45°$, particularly preferred $5° \leq \sigma_p \leq 25°$ is blocked through the interaction of the structural layers (5, 6).

**13.** The sun protection device according to any one of the Claims 10 to 12,
**characterized in that**
the first (5) and/or second structural layer (6) is/are formed from a material comprising a light translucence of $\leq 40\%$, preferentially $\leq 10\%$, particularly preferred $\leq 3\%$.

**14.** The sun protection device according to Claim 13,
**characterized in that**
the first (5) and/or second structural layer (6) is/are formed of a material which comprises a directed diffuse transmission degree which amounts to less than 20% of a total transmission degree of the material.

**15.** The sun protection device according to any one of the Claims 10 to 14,
**characterized in that**
the first (5) and/or second structural layer (6) is formed of a material with a switchable transmission degree, in particular with an electrochromic or gasiochromic material.

**Revendications**

**1.** Dispositif pare-soleil, en particulier vitrage, lequel comprend au moins une première couche structurée (5) en un matériau opaque ou seulement partiellement transparent sur une couche ou suite de couches diélectrique à transparence optique (1, 7) et une deuxième couche structurée (6) en un matériau opaque ou seulement partiellement transparent, dans lequel les première (5) et deuxième (6) couches structurées sont structurées en formant des ouvertures ou zones de passage de lumière (14) et des zones non transparentes ou d'atténuation de la lumière (12, 13),
dans lequel la deuxième couche structurée (6) est reliée, sur un côté de la couche ou suites de couches à transparence optique (1, 7) situé en vis-à-vis de la première couche structurée (5), à celle-ci, et les deux couches structurées (5, 6) étant structurées de manière à ce que, selon une plage angulaire prescrite qui est définie dans un plan de référence orienté perpendiculairement à la deuxième couche structurée (6), un rayonnement optique incident sur la deuxième couche structurée (6) soit bloqué ou atténué grâce à la coopération entre les deux couches structurées (5, 6) et qu'une part du rayonnement optique, laquelle est incidente selon une autre plage angulaire par rapport au même plan de référence sur la deuxième couche structurée (6), puisse traverser sans encombre les couches structurées (5, 6),
dans lequel les zones non transparentes (13) de la deuxième couche structurée (6) sont formées par des cellules solaires, en particulier des cellules solaires amorphes,
**caractérisé en ce que**
un côté intérieur de la première couche structurée orienté vers la deuxième couche structurée est réalisé de manière réfléchissante de telle sorte que la deuxième couche structurée est éclairée indirectement par un rayonnement optique incident sur le côté intérieur de la première couche structurée.

2. Dispositif pare-soleil selon la revendication 1,
   **caractérisé en ce que**
   la deuxième couche structurée (6) est reliée, sur un côté situé en vis-à-vis de la couche ou suite de couches à transparence optique (1, 7), à une deuxième couche ou suite de couches diélectrique à transparence optique (2), en particulier avec une plaque en verre ou en plastique.

3. Dispositif pare-soleil selon la revendication 2,
   **caractérisé en ce que**
   la couche ou suite de couches à transparence optique (1, 7) comprend une plaque en verre ou en plastique (1) avec un film adhésif (7) par l'intermédiaire duquel la plaque en verre ou en plastique (1) est reliée de manière fixe à la deuxième couche structurée (6) et la plaque en verre ou en plastique de la deuxième couche ou suite de couches à transparence optique (2).

4. Dispositif pare-soleil selon l'une des revendications 1 à 3,
   **caractérisé en ce que**
   les deux couches structurées (5, 6) sont structurées de telle sorte qu'en cas d'un agencement perpendiculaire, de la lumière incidente depuis le haut soit bloquée ou atténuée et que de la lumière incidente depuis le bas puisse passer selon une proportion définie.

5. Dispositif pare-soleil selon l'une des revendications 1 à 4,
   **caractérisé en ce que**
   les zones non transparentes ou d'atténuation de la lumière (13) de la deuxième couche structurée (6) occupent une plus petite surface que les zones non transparentes ou d'atténuation de la lumière (12) de la première couche structurée (5).

6. Dispositif pare-soleil selon l'une des revendications 1 à 5, **caractérisé en ce que**
   la première couche structurée (5) est reliée, sur un côté situé en vis-à-vis de la couche ou suites de couches à transparence optique (1, 7), à une troisième couche ou suite de couches diélectrique à transparence optique (3, 8).

7. Dispositif pare-soleil selon la revendication 6,
   **caractérisé en ce que**
   la troisième couche ou suite de couches à transparence optique (3, 8) comprend une plaque en verre ou en plastique (3), laquelle est reliée par l'intermédiaire d'un film adhésif (8) à la première couche structurée (5) et à la couche ou suite de couches à transparence optique (1, 7).

8. Dispositif pare-soleil selon l'une des revendications 1 à 7,
   **caractérisé en ce que**
   les deux couches structurée (5, 6) forment, avec les couches ou suites de couches à transparence optique reliées à celles-ci, un élément de vitrage extérieur (9) d'un double vitrage où il existe, entre l'élément de vitrage extérieur (9) et un élément de vitrage intérieur (4), un espace intermédiaire (10) rempli avec un gaz ou un mélange de gaz.

9. Dispositif pare-soleil selon la revendication 8,
   **caractérisé en ce que**
   l'élément de vitrage intérieur (4) est doté, sur un côté orienté vers l'espace intermédiaire (10), d'un revêtement de protection contre le soleil ou la chaleur (11).

10. Dispositif pare-soleil selon l'une des revendications 1 à 9,
    **caractérisé en ce que**
    les zones non transparentes ou d'atténuation de la lumière (12, 13) des deux couches structurées (5, 6) forment des bandes s'étendant parallèlement entre elles.

11. Dispositif pare-soleil selon la revendication 10,
    **caractérisé en ce que**
    des lignes de liaison droites entre des arêtes supérieures tournées l'une vers l'autre de bandes situées respectivement le plus près des deux couches structurées (5, 6) s'étendent dans le plan de référence, en partant de la première couche structurée, selon un angle $\alpha$ à la normale à la surface (18), vers les couches structurées (5, 6), pour lequel angle s'applique ce qui suit : -34°$\leq \alpha \leq$ 60°, de préférence 0° $\leq \alpha \leq$ 42°, de manière particulièrement préférée, 27° $\leq \alpha \leq$ 42°, idéalement $\alpha = \sigma_{Grenz}$, où $\sigma_{Grenz}$ est l'angle limite de la réflexion totale,

**en ce que** des lignes de liaison droites entre des arêtes supérieures des bandes de la deuxième couche structurée (6) et des arêtes inférieures des bandes de la première couche structurée (5) de bandes respectivement les plus proches des deux couches structurées (5, 6) s'étendent dans le plan de référence, en partant de la première couche structurée (5), selon un angle $\gamma$ à la normale à la surface (18), vers les couches structurées (5, 6), pour lequel angle s'applique ce qui suit : -30° $\leq \gamma \leq$ 80°, de préférence $\sigma_{Grenz} \leq \gamma \leq$ 80°, de manière particulièrement préférée $\sigma_{Grenz} \leq \gamma \leq (\sigma_{Grenz} + 20°)$, idéalement $\gamma = \sigma_{Grenz}$, où $\sigma_{Grenz}$ est l'angle limite de la réflexion totale, et

**en ce que** des lignes de liaison droites entre des arêtes tournées l'une vers l'autre de bandes respectivement les plus proches des deux couches structurées (5, 6) s'étendent dans le plan de référence, en partant de la première couche structurée (5), selon un angle $\beta$ à la normale à la surface (18), vers les couches structurées (5, 6), pour lequel angle s'applique ce qui suit : -34° $\leq \beta \leq$ 60°, de préférence -10° $\leq \beta \leq$ 15°, de manière particulièrement préférée, $\beta = 0°$.

12. Dispositif pare-soleil selon la revendication 10,
**caractérisé en ce que**,
en cas d'utilisation du dispositif pare-soleil dans une orientation fixée de la normale à la surface par rapport à l'horizontale (19), une distance D entre les arêtes supérieure et inférieure de bandes respectivement voisines de la première couche structurée (5) est choisie de manière à ce qu'un rayonnement solaire soit bloqué à partir d'un angle d'incidence solaire $\sigma_p$ de -20° $\leq \sigma_p \leq$ 70°, de préférence de 0° $\leq \sigma_p \leq$ 45°, de manière particulièrement préférée, de 5° $\leq \sigma_p \leq$ 25°, grâce à la coopération des couches structurées (5, 6).

13. Dispositif pare-soleil selon l'une des revendications 10 à 12,
**caractérisé en ce que**
la/les première (5) et/ou deuxième (6) couche(s) structurée(s) sont formées en un matériau qui présente une transparence $\leq$ 40%, de préférence $\leq$ 10%, de manière particulièrement préférée, $\leq$ 3%.

14. Dispositif pare-soleil selon la revendication 13,
**caractérisé en ce que**
la/les première (5) et/ou deuxième (6) couche(s) structurée(s) sont formées en un matériau qui présente un facteur de transmission diffus de manière orientée qui représente moins de 20% d'un facteur de transmission global du matériau.

15. Dispositif pare-soleil selon l'une des revendications 10 à 14,
**caractérisé en ce que**
la/les première (5) et/ou la deuxième (6) couche(s) structurée(s) sont formées en un matériau avec un facteur de transmission commutable, en particulier un matériau électrochrome ou gazochrome.

transparente Klebeschicht

Fig. 1

z.B. PVB n ca. 1,5

Fig. 2

Fig. 3

Fig.4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10161159 A1
- DE 10139583 A1
- US 3453039 A
- DE 19611060 A1
- EP 0170472 A2

**In der Beschreibung aufgeführte Nicht-Patentliteratur**

- **W. LORENZ.** A Glazing Unit for Solar Control, Day Lighting and Energy Conservation. *Solar Energy,* 2001, vol. 70 (2), 109-130